# EUROPÄISCHE PATENTANMELDUNG

(11) **EP 2 733 796 A2**
(43) Veröffentlichungstag der Anmeldung: **21.05.2014**
(21) Anmeldenummer: 13192593.5
(22) Anmeldetag: 12.11.2013
(51) Int. Cl.: H01S 3/102, H01S 3/113, B23K 26/06, H01S 3/094, H01S 3/0941, H01S 5/062

(54) **Markierungsvorrichtung mit Laseranordnung**

(30) Priorität: 15.11.2012 DE 102012110974; 22.02.2013 DE 102013101760
(71) Anmelder: mobil-mark GmbH, 89134 Blaustein (DE)
(72) Erfinder: Baeger, Holm, Dr., 89134 Blaustein (DE)
(74) Vertreter: Baur & Weber Patentanwälte

(57) **Zusammenfassung**

Für eine Markierungsvorrichtung mit einer Laseranordnung wird vorgeschlagen, eine Betriebsart vorzusehen, bei welcher ein Diodenstrom durch eine als Pumplichtquelle dienende Diodenanordnung zyklisch zwischen einem oberen Stromwert (OS) und einem unteren Stromwert (US) durch eine Steuereinrichtung nach Maßgabe eines auf einer Werkstückoberfläche zu erzeugenden Musters umgeschaltet ist. Der obere Stromwert (OS) kann dabei vorteilhafterweise wesentlich höher liegen als der für die Diodenanordnung vorgegebene Grenzwert für Dauerstrombetrieb. Es zeigt sich, dass ohne die Gefahr der thermischen Zerstörung bei der Betriebsart mit umgeschaltetem Diodenstrom eine wesentlich höhere Pulsfolgefrequenz eines mit dem Pumplicht beaufschlagten Laserresonators erreichbar ist. Vorteilhafterweise können Parameter der zeitveränderlichen Steuerung des Diodenstroms auch während eines zeitlich zusammen hängenden Markierungsvorgangs variiert und somit die Möglichkeiten bei der Erzeugung von Mustern ausgeweitet werden. Die Laseranordnung beinhaltet zwei Resonatorspiegel (M1, M2), einen Laserkristall (LK) und einen passiven Güteschalter (QS). Die Anordnung wird longitudinal von Laserdioden gepumpt (PL). Während einem Pumpzyklus (Z1) werden in Abhängigkeit vom oberen Stromwert des Diodenstroms (OS) eine Vielzahl von Lichtpulsen (LP) in einem vom Diodenstrom abhängigen Zeitabstand (TU) emittiert.

## Beschreibung

Die Erfindung betrifft eine Markierungsvorrichtung mit einer Laseranordnung zur Oberflächenbearbeitung, insbesondere zur materialabtragenden Bearbeitung eines Werkstücks.

Markierungsvorrichtungen mit Materialabtrag von der Oberfläche eines Werkstücks durch Einwirkung eines fokussierten Laserstrahls sind beispielsweise aus der DE 100 59 246 C2 bekannt. Solche Markierungsvorrichtungen sind nicht nur, aber insbesondere zur Markierung von harten Materialien, wie Glas, Metall oder Keramik von besonderer Bedeutung. Als Markierung sei dabei jede optisch erkennbare flächige Strukturierung, insbesondere auch nach Art einer Beschriftung der Werkstückoberfläche angesehen.

Durch Einwirkung eines fokussierten Laserstrahls auf die Werkstückoberfläche werden mikroskopische Partikel aus dieser herausgelöst, so dass die erzeugte Markierung gegen mechanische Einwirkung beim späteren Gebrauch des Werkstücks im Unterschied zu auf eine Werkstückoberfläche aufgebrachten Beschichtungsmaterial besonders langzeitstabil ist. Zur Erzeugung eines gewünschten Markierungsmusters, welches alphanumerische Zeichen, Symbole, flächige Codierungen u. ä. enthalten kann, wird der Laserstrahl mittels einer steuerbaren Strahloptik, welche insbesondere wenigstens eine Fokussierlinse und einen oder mehrere motorisch schwenkbare Spiegel enthalten kann, über die Werkstückoberfläche bewegt. Der Laserstrahl wird bei einer gattungsgemäßen Laseranordnung in allgemein gebräuchlicher Art in einem optisch gepumpten Lasermaterial, welches in einem optischen Resonator angeordnet ist, erzeugt. Als Pumplichtquelle dient eine lichtemittierende Diodenanordnung, welche auch eine Mehrzahl einzelner Dioden, insbesondere Laserdioden enthalten kann. Das Lasermaterial ist typischerweise durch einen Laserkristall gebildet, was insbesondere von Vorteil ist für Markierungsvorrichtungen mit einem von Hand beweglichen Arbeitskopf, in welchem der Resonator und die Strahloptik angeordnet sind.

Eine mobile, durch einen Benutzer von Hand verfahrbare Laser-Markierungsvorrichtung dieser Art mit einem handhaltbaren Arbeitskopf ist beispielsweise als "mobil-mark 1" der mobil mark GmbH bekannt. Das Gerät ist zwischen cw-Laserbetrieb und, durch Einschwenken eines passiven Güteschalters (Q-switch) in den Resonator, Puls-Laserbetrieb umschaltbar.

Der vorliegenden Erfindung liegt die Aufgabe zugrunde, eine Markierungsvorrichtung mit erhöhter Einsatzflexiblität und/oder Effizienz anzugeben.

Erfindungsgemäße Lösungen sind in den unabhängigen Ansprüchen beschrieben. Die abhängigen Ansprüche enthalten vorteilhafte Ausgestaltungen und Weiterbildungen der Erfindung.

Die Kombination eines passiven Güteschalters mit einer zyklisch zwischen einem oberen Stromwert und einem unteren Stromwert nach Maßgabe einer elektronischen Steuereinrichtung umgeschalteten Diodenanordnung als Pumplichtquelle ermöglicht auf besonders einfache und vorteilhafte Weise eine allein über die elektronische Steuereinrichtung und eine von dieser ansteuerbare Einrichtung zur Einstellung eines gewünschten Diodenstroms durch die Diodenanordnung der Pumplichtquelle flexibel veränderliche Betriebsart im Puls-Laserbetrieb. Insbesondere können Parameter der Pulslaser-Betriebsart auch während der Abarbeitung eines zeitlich zusammen hängenden Markierungsvorgangs, während dessen vorzugsweise ein Arbeitskopf der Markierungsvorrichtung in konstanter Position am Werkstück gehalten ist, über die Steuereinrichtung verändert werden. Der Arbeitskopf der Markierungsvorrichtung ist vorteilhafterweise relativ zu einem Grundgehäuse der Bearbeitungsvorrichtung verlagerbar und ist vorzugsweise handhaltbar ausgeführt.

Vorteilhafterweise kann durch die Umschaltung des Diodenstroms der obere Stromwert wesentlich höher gewählt sein als ein für die Diodenanordnung für Dauerbetrieb spezifizierter Grenzwert für den Diodenstrom. Es zeigt sich, das während eines ersten Zyklusabschnitts, in welchem ein Diodenstrom mit dem oberen Stromwert durch die Pumplicht-Diodenanordnung fließt, die Wiederholfrequenz der Laserpulse wesentlich höher sein kann als bei einem dem Durchschnitts-Stromwert über dem Zyklus entsprechenden Konstantstrom. Auch kann mit zyklischer Umschaltung des Diodenstroms eine Gesamtzahl von Laserpulsen in dem ersten Abschnitt erreicht werden, welche deutlich höher ist als die Anzahl von Laserpulsen über eine Zyklusdauer bei dem genannten, dem Durchschnittsstromwert entsprechenden Konstantstrom. Es zeigt sich, dass die Pulsfolgefrequenz von Laserpulsen während des ersten Zyklusabschnitts über die Höhe des ersten Stromwerts steuerbar ist. Es zeigt sich ferner, dass überraschenderweise die Maxima der Laserpulse während eines ersten Zyklusabschnitts weniger schwanken und im Mittel höher sind als bei konstanter Pumplichtleistung mit konstantem Diodenstrom.

Die Erfindung nutzt dabei auch vorteilhaft die von sogenannten QCW-Diodenanordnungen an sich bekannte Eigenschaft aus, dass durch den umgeschalteten Betrieb der Dioden durch sehr hohe Effizienzwerte eine besonders hohe Lichtleistung gegenüber dem CW-Betrieb mit konstantem Diodenstrom erreichbar ist. QCW-Diodenanordnungen sind als Pumplichtquellen für Festkörperlaser an sich bekannt, dienen dabei aber typischerweise zur Erzeugung im Takt der Umschaltung des Diodenstroms an und aus geschaltetem Laserstrahl. Demgegenüber erzeugt die erfindungsgemäße Markierungsvorrichtung während der Einschaltzeit der Pumplichtquelle eine schnelle Folge von Laserpulsen mit einer Pulsfolgefrequenz, welche wesentlich höher liegt als die Umschaltfrequenz des Diodenstroms und welche durch Veränderung von Parametern des umgeschalteten Diodenstroms beeinflussbar ist.

Die Steuereinrichtung kann vorteilhafterweise zur Veränderung wenigstens einer, vorzugsweise mehrerer oder aller Größen von
- oberem Stromwert,
- Zyklusdauer,
- Länge des ersten und/oder zweiten Zyklusabschnitts

innerhalb der einen Betriebsart eingerichtet sein. In vorteilhafter Weiterbildung kann die Steuereinrichtung darüber hinaus auch zum Betrieb der Laseranordnung bzw. einer diese enthaltenden Markierungsvorrichtung in wenigstens einer weiteren Betriebsart, insbesondere einer Betriebsart mit konstantem Diodenstrom eingerichtet sein. Vorteilhafterweise beträgt der untere Stromwert weniger als 10 %, insbesondere weniger als 5 % des oberen Stromwerts. Vorzugsweise kann der untere Stromwert in dem zweiten Zyklusabschnitt auch gleich oder annähernd Null sein, so dass die Umschaltung des Stromwerts einem Ein- und Ausschalten des Diodenstroms entspricht. Der untere Stromwert kann vorteilhafterweise so eingestellt sein, dass die Emissionsschwelle der Diodenanordnung fast erreicht ist, um ein schnelles Einschalten der Lichtemission zu begünstigen. Hierfür kann auch eine Vorspannung an die Diodenanordnung angelegt sein.

Der obere Stromwert beträgt vorteilhafterweise mehr als 150 % des für die Diodenanordnung der Pumplichtquelle spezifiziertem Grenzwerts für konstanten Dauerstrom. Vorteilhafterweise beträgt der obere Stromwert mehr als 150 % des über einen Zyklus gemittelten Stromwerts. Die Lichtleistung der Diodenanordnung steigt dabei in an sich von QCW-Diodenanordnungen bekannter Weise überproportional gegenüber einer Betriebsart mit konstantem Strom des gemittelten Stromwerts.

Der Zeitverlauf des Diodenstroms bildet vorteilhafterweise im wesentlichen ein Rechtecksignal mit annähernd verzögerungsfreier abwechselnder Umschaltung zwischen dem oberen und dem unteren Stromwert.

Die Länge des ersten Zyklusabschnitts beträgt vorteilhafterweise wenigstens 15 %, vorzugsweise wenigstens 25 % der Zyklusdauer. Vorteilhafterweise beträgt die Länge des ersten Zyklusabschnitts höchstens 75 %, vorzugsweise höchstens 65 % der Zyklusdauer. Die Länge des ersten Zyklusabschnitts ist vorteilhafterweise nicht kleiner als 300 µs. Die Zyklusdauer beträgt vorteilhafterweise nicht mehr als 2,5 ms. Vorteilhafterweise ist die Zyklusdauer größer als 400 µs. In weiteren Betriebsarten können Längen der Zyklusdauer und der Zyklusabschnitte andere Werte annehmen.

Vorteilhafterweise sind die von der Steuereinrichtung veränderlichen Parameter, insbesondere Höhe des ersten Stromwerts und Länge des ersten Zyklusabschnitts so eingestellt, dass innerhalb eines ersten Zyklusabschnitts wenigstens vier Laserpulse auftreten. Die Wiederholfrequenz der Laserpulse innerhalb eines ersten Zyklusabschnitts beträgt vorteilhafterweise wenigstens 8 kHz, insbesondere wenigstens 15 kHz.

Bei kontinuierlicher Bewegung der Spiegelanordnung können anstelle gleichmäßiger Punktfolgen abwechselnd dichte Punktfolgen entsprechend den Laserpulsen im ersten Zyklusabschnitt und Lücken entsprechend den zweiten Zyklusabschnitten in einem linienförmigen Musterabschnitt auftreten. Aufgrund der kurzen Länge solcher Lücken treten diese normalerweise nicht störend in Erscheinung. Soweit solche Lücken in linienförmigen Punktfolgen weitgehend vermieden werden sollen, kann die Steuereinrichtung entweder eine ungleichmäßige, entsprechend den Zyklusabschnitten schneller und langsamer erfolgende Bewegung der Spiegelanordnung vorgegeben oder vorzugsweise in den betroffenen Musterabschnitten wenigstens einen zweiten Durchlauf des Laserstrahls veranlassen, bei welchem dann die ersten Zyklusabschnitte zeitlich so eingestellt sind, dass der Laserstrahl in den bei dem ersten Durchlauf verbliebenen Lücken eines vorgesehenen linienförmigen Musterabschnitts auf die Werkstückoberfläche trifft.

Die Erfindung ist nachfolgend anhand bevorzugter Ausführungsbeispiele unter Bezugnahme auf die Abbildungen noch eingehend veranschaulicht. Dabei zeigt:
- Fig. 1: ein mobiles Laser-Markierungsgerät,
- Fig. 2: einen Laser-Resonator,
- Fig. 3: ausgewählte Gerätekomponenten als Blockschaltbild,
- Fig. 4: Signalverläufe bei umgeschaltetem Diodenstrom,
- Fig. 5: Signalverläufe bei konstantem Diodenstrom.

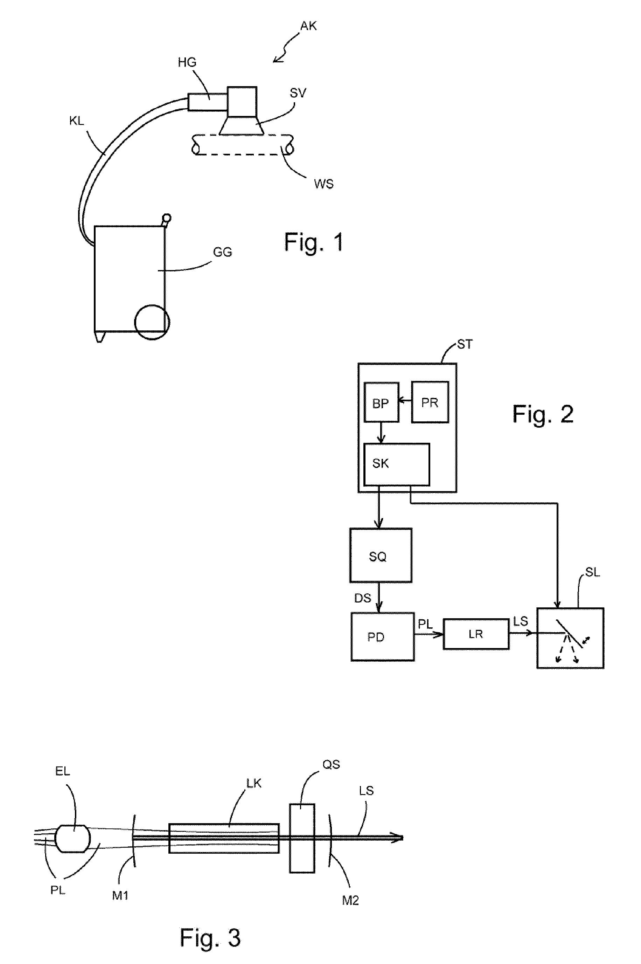

Fig. 1 zeigt in schematischer Darstellung eine Laser-Markierungsvorrichtung, wie sie auch als "mobil-mark 1" auf dem Markt erhältlich ist. Die Vorrichtung enthält in der in Fig. 1 dargestellten Skizze ein fahrbares Grundgerät GG, einen Arbeitskopf AK sowie eine den Arbeitskopf AK mit dem Grundgerät GG verbindenden Leitungsstrang KL. Der Arbeitskopf ist im Verhältnis zum Grundgerät stark vergrößert dargestellt. Der handhaltbare Arbeitskopf AK enthält insbesondere einen Handgriff HG und eine Schutzvorrichtung SV und ist mit letzterer auf eine Oberfläche eines Werkstückes WS, welches mit unterbrochener Linie dargestellt ist, aufsetzbar. Im Arbeitskopf AK kann insbesondere ein in Fig. 2 schematisch dargestellter, an sich bekannter Laserresonator und eine Strahloptik mit einer steuerbaren Spiegelanordnung zur zweidimensionalen Schwenkung eines im Laserresonator erzeugten Laserstrahls angeordnet sein. Der Leitungsstrang KL kann insbesondere einen Lichtwellenleiter zur Pumplichtübertragung, gasführende Leitungen für eine Absaugeinrichtung und elektrische Versorgungs- und Steuerleitungen enthalten. Eine Pumplichtquelle, mit einer lichtemittierenden Diodenanordnung, welche insbesondere eine oder mehrere Laserdioden enthalten kann, ist zusammen mit einer veränderlich steuerbaren Stromquelle, welche nach Maßgabe einer Steuereinrichtung einen zeitlich veränderbaren Diodenstrom vorgibt, im Grundgerät GG angeordnet, so dass Volumen und Gewicht des handhaltbaren Arbeitskopfes AK vorteilhaft gering gehalten werden können. Die Erfindung ist anhand einer solchen mobilen Markierungsvorrichtung mit handhaltbarem Arbeitskopf als bevorzugter Ausführung beschrieben, ist aber nicht auf mobile Markierungsvorrichtungen und/oder Markierungsvorrichtungen mit handhaltbarem Arbeitskopf beschränkt.

Fig. 2 zeigt schematisch den an sich gebräuchlichen Aufbau eines Laserresonators, bei welchem zwischen zwei Endspiegeln M1 und M2 ein Laserkristall LK und ein passiver Güteschalter QS angeordnet sind. Pumplicht PL von einer Pumplichtquelle wird über eine Einkoppellinse EL durch den Spiegel M1 und den Güteschalter hindurch in den Laserkristall LK geführt und bewirkt dort in gebräuchlicher Art eine Besetzungsinversion. Ab einem bestimmten Niveau werden die Verluste im passiven Güteschalter schlagartig reduziert, der Laser kann anschwingen und die Besetzungsinversion wird unter Abgabe eines Laserimpulses durch den Spiegel M2 wieder abgebaut, worauf der Güteschalter wieder in einen Zustand hoher Verluste übergeht. Die Wirkungsweise solcher Laseranordnungen mit passiven Güteschaltern ist grundsätzlich bekannt und gebräuchlich.

Die aus dem Laserresonator durch den Endspiegel M2 austretenden Laserpulse werden in einer Strahloptik typischerweise über darin enthaltene Linsen auf die Oberfläche des Werkstücks fokussiert und in ihrer Auftreffposition auf die Werkstückoberfläche mittels einer motorisch bewegbaren, durch eine Steuereinrichtung steuerbaren Spiegelanordnung zweidimensional über die Werkstückoberfläche bewegt.

Fig. 3 zeigt schematisch als Blockschaltbild ausgewählte Komponenten der Laser-Markierungsvorrichtung. In einem vorzugsweise programmierbaren Speicher PR einer Steuereinrichtung ST kann ein auf einer Werkstückoberfläche zu erzeugendes Muster als digitale Datei abgelegt werden. Die Steuereinrichtung ST greift auf das abgespeicherte Muster zu, um weitere Komponenten der Laser-Markierungsvorrichtung mit nach Maßgabe des zu erzeugenden Musters generierten Steuersignalen anzusteuern. Die Steuereinrichtung kann insbesondere einen handelsüblichen programmierbaren Rechner enthalten, auf welchen ein spezielles Markierungssteuerungsprogramm BP geladen ist.

Insbesondere kann die Steuereinrichtung ST dazu ausgebildet sein, eine Stromquelle SQ so anzusteuern, dass diese einer Diodenanordnung PD als Pumplichtquelle einen zeitveränderlichen Diodenstrom DS aufprägt. Die Steuereinrichtung kann hierfür beispielsweise eine eigens hierfür ausgelegte Steckkarte SK als Steuerkarte für eine außerhalb der Steuereinrichtung angeordnete steuerbare Stromquelle enthalten. Die Steuerkarte SK kann beispielsweise nach Maßgabe der gespeicherten Musterdatei und des Markierungssteuerprogramms Signale für unteren und oberen Stromwert und ein die Umschaltfrequenz und Länge der Zyklusabschnitte beinhaltendes Rechtecksignal erzeugen.

Entsprechend dem zeitveränderlichen Verlauf des Diodenstroms DS gibt die Diodenanordnung Pumplicht PL in zeitveränderlicher Intensität an den im Arbeitskopf AK angeordneten Laserresonator LR, insbesondere an den Laserkristall LK ab. In Zusammenwirken des Laserkristalls LK und des passiven Güteschalters werden im Laserresonator kurze Laserimpulse, welche in Fig. 3 allgemein als Laserstrahl LS bezeichnet sind, erzeugt und auf eine Strahloptik SL geleitet.

Die Steuereinrichtung ST ist zugleich, insbesondere über die Steuerkarte SK, zur Steuerung der steuerbaren Komponenten der Strahloptik SL, insbesondere einer Schwenkspiegelanordnung eingerichtet. Nach Maßgabe des im Speicher PR gespeicherten, auf der Oberfläche des Werkstücks WS zu erzeugenden Musters koordiniert die Steuereinrichtung die zeitveränderliche Vorgabe des Diodenstroms DS und damit zeitveränderlich das Pumpen des Laserkristalls LK im Laserresonator LR mit der Bewegung der Schwenkspiegelanordnung, um durch Einwirkung der fokussierten Laserpulse auf die Werkstückoberfläche das gewünschte Muster zu erzeugen. Die Erzeugung eines Musters in der Werkstückoberfläche erfolgt dabei typischerweise durch Auslösen mikroskopisch kleiner Partikel aus der Werkstückoberfläche durch den kurzzeitig hohen Energieeintrag über den fokussierten Laserstrahl LS.

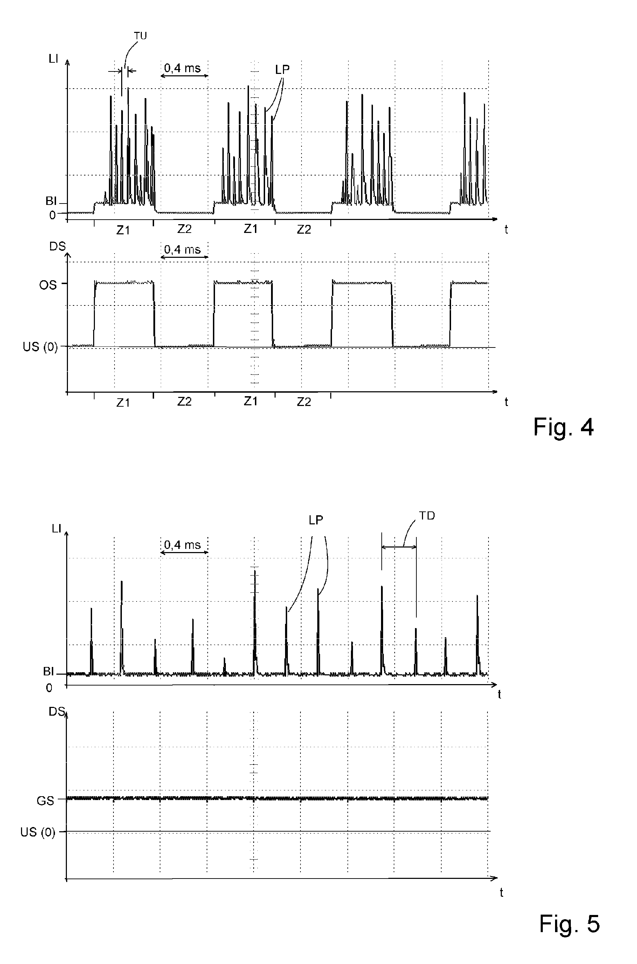

Gemäß der vorliegenden Erfindung ist für die Markierungsvorrichtung, eine Betriebsart vorgesehen, in welcher die Steuereinrichtung den Diodenstrom DS, mit welchem die Stromquelle SQ die Diodenanordnung PD der Pumplichtquelle beaufschlagt, mit einer Umschaltfrequenz von vorzugsweise wenigstens 400 Hz zwischen einem oberen Stromwert und einem unteren Stromwert umschaltet. Dabei liegt der obere Stromwert höher als der für die Diodenanordnung bei Dauerstrom zulässige Stromgrenzwert, insbesondere bei wenigstens 150 % dieses Dauerstrom-Grenzwerts. Der untere Stromwert beträgt vorteilhafterweise nicht mehr als 10 % des oberen Stromwerts und liegt vorzugsweise zumindest annähernd bei Null (0), so dass eine Umschaltung des Diodenstroms zwischen dem oberen Stromwert und dem unteren Stromwert im wesentlichen ein zyklisches Ein- und Ausschalten der Diodenanordnung bedeutet. Die Umschaltung erfolgt vorteilhafterweise annähernd verzögerungsfrei, so dass sich für den Zeitverlauf des Diodenstroms das in Fig. 4 unten dargestellte annähernd rechteckförmige Zeitsignal ergibt. Durch das zyklische Ein- und Ausschalten kann der durch den oberen Stromwert OS gebildete Spitzenstrom durch die Diodenanordnung höher gewählt werden als der für die Diodenanordnung vorgegebene Grenzwert im Dauerstrombetrieb. Durch die Umschaltfrequenz von wenigstens 400 Hz kann die Diode in zweiten Zyklusabschnitten Z2, in welchen der Diodenstrom DS niedrig oder gleich Null (0) ist, wieder abkühlen, so dass trotz des über dem Grenzwert GS für Dauerstrom liegenden oberen Stromwerts OS in den ersten Zyklusabschnitten Z1 keine thermische Zerstörung der Diodenanordnung auftritt.

Ein Laserbetrieb ergibt sich nur während des Einwirkens von Pumplicht auf den Laserkristall im Laserresonator. Da die Lichtemission der Diodenanordnung im wesentlichen verzögerungsfrei dem Verlauf des Zeitsignals des Diodenstroms folgt, ergibt sich ein zyklisches Ein- und Ausschalten des auf den Laserresonator einwirkenden Pumplichtes. Eine Laseraktivität im Laserresonator mit Abgabe von Laserpulsen ist daher, abgesehen von Ein- und Ausschwingvorgängen, nur während des Einwirkens von Pumplicht in den ersten Zyklusabschnitten Z1 mit dem Diodenstrom beim oberen Stromwert OS gegeben.

Es zeigt sich überraschend, dass während der ersten Zyklusabschnitte mit Einwirkung des Pumplichts mit einer durch den oberen Stromwert gegebenen Intensität eine schnelle Folge von Laserpulsen LP innerhalb der Dauer der ersten Zyklusabschnitte Z1 auftritt, wie in der oberen Hälfte der Fig. 4, welche die im ausgekoppelten Laserstrahl LS gemessene Laserlichtintensität LI über der Zeit t zeigt, dargestellt ist.

In Fig. 5 ist zum Vergleich eine weitere Betriebsart der Laseranordnung dargestellt, in welcher der Laserstrom einen Stromwert GS einnimmt. Der Stromwert GS ist dabei zur vergleichenden Veranschaulichung auf einen dem gemittelten Stromwert der umgeschalteten Betriebsart nach Fig. 4 eingestellt. Der Stromwert GS darf in der Konstantstrom-Betriebsart nach Fig. 5 einen für die Diodenanordnung gegebenenfalls spezifizierten Grenzwert für Dauerstrom nicht überschreiten. In dieser Betriebsart treten Laserimpulse LP in annähernd regelmäßigen Zeitabständen TD auf, wobei die Lichtintensität der einzelnen Pulse über einer Basis-Intensität BI starken Schwankungen unterworfen ist. Der zeitliche Abstand TD der einzelnen Laserpulse bei der in Fig. 5 anhand von Zeitsignalen dargestellten Betriebsart mit konstantem Diodenstrom liegt im Mittel knapp über 300 µs entsprechend einer Pulswiederholfrequenz von ca. 3 kHz. Das Rastermaß der Diagramme in Zeitrichtung beträgt im Beispielsfall 400 µs. Im Unterschied dazu liegt die Pulsfolgefrequenz bei der in Fig. 4 anhand von analogen Diagrammen dargestellten Betriebsart mit zyklischem Umschalten des Diodenstroms in den ersten Zeitabschnitten Z1 mit ca. 20 kHz Pulsfolgefrequenz entsprechend einer mittleren Pulsfolgedauer TU von ca. 50 µs wesentlich höher. Auch bei über erste und zweite Zyklusabschnitte Z1, Z2 gemittelter Betrachtung ist die Pulshäufigkeit je Zeiteinheit noch rund doppelt so hoch wie in dem in Fig. 5 dargestellten Fall der Betriebsart mit konstantem Dauerstrom durch die Diodenanordnung. Es zeigt sich ferner, dass die Intensität der einzelnen Laserpulse bei der in Fig. 4 dargestellten Betriebsart mit umgeschaltetem Diodenstrom nicht in dem Ausmaße schwankt wie bei der in Fig. 5 dargestellten Betriebsart und im Mittel höher ist.

Im Falle der Diagramme nach Fig. 4 zu der Betriebsart mit zyklisch umgeschaltetem Diodenstrom sind die Zeitdauern von erstem Zyklusabschnitt Z1 und zweitem Zyklusabschnitt Z2 gleich lang gewählt und betragen jeweils ca. 500 µs. Die Zyklusfrequenz der Umschaltung beträgt damit ca. 1 kHz und die Zyklusdauer 1 ms. Bei einem anderen Tastverhältnis zwischen erstem Zyklusabschnitt Z1 und zweitem Zyklusabschnitt Z2 kann die Höhe des oberen Stromwerts OS variieren. Insbesondere kann bei anteilmäßig kürzerer Zeitdauer des ersten Zyklusabschnitts bezogen auf die gesamte Zyklusdauer der obere Stromwert weiter heraufgesetzt werden. Es zeigt sich dabei, dass die Wiederholfrequenz der Pulse innerhalb eines ersten Zyklusabschnitts mit zunehmendem Wert des oberen Stromwerts OS ansteigt.

Die Steuereinrichtung kann bei der Ansteuerung der Diodenanordnung PD als Pumplichtquelle vorteilhafterweise wenigstens einen, vorzugsweise mehrere Parameter von oberem Diodenstrom, Zyklusdauer und Länge des ersten bzw. zweiten Zyklusabschnitts variieren. Vorteilhafterweise kann eine solche Variation von Parametern auch innerhalb der Abwicklung eines Markierungsvorgangs, während dessen der Arbeitskopf in gleichbleibender Position auf einem Werkstück gehalten ist, ausgeführt werden, so dass sich eine größere Variationsbreite für die Gestaltung von Mustern durch flexiblere zeitlich Variation der Lasereinwirkung auf die Werkstückoberfläche ergibt.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

## Patentansprüche

1. Markierungsvorrichtung zur Oberflächenbearbeitung eines Werkstücks,
- mit einer Laseranordnung, welche
mit einen in einem Resonator angeordneten Festkörperlaser, eine Diodenanordnung als Pumplichtquelle, einen Güteschalter im Resonator enthält und einen gepulsten Laserstrahl erzeugt,
- mit einer zur Bewegung des Laserstrahls über die Werkstückoberfläche eingerichteten Spiegelanordnung,
- mit einer Steuereinrichtung zur zeitlich veränderlichen Steuerung des Diodenstroms durch die Diodenanordnung und zur Steuerung der Spiegelanordnung.
wobei die Steuereinrichtung in zumindest einer Betriebsart mit zyklischer Umschaltung des Diodenstroms zwischen einem oberen Stromwert in einem ersten Zyklusschritt und einem unteren Stromwert in einem zweiten Zyklusabschnitt betreibbar ist, und wobei der Güteschalter als ein passiver Güteschalter ausgeführt ist.

2. Markierungsvorrichtung nach Anspruch 1, **dadurch gekennzeichnet, dass** der untere Stromwert weniger als 10 % des oberen Stromwerts beträgt.

3. Markierungsvorrichtung nach Anspruch 1 oder 2, **dadurch gekennzeichnet, dass** der obere Stromwert mehr als 150 % des Grenzwerts für Dauerstrom durch die Diodenanordnung beträgt.

4. Markierungsvorrichtung nach Anspruch 1 oder 2, **dadurch gekennzeichnet, dass** der obere Stromwert mehr als 150 % des über einen Zyklus gemittelten Stromwerts beträgt.

5. Markierungsvorrichtung nach einem der Ansprüche 1 bis 4, **dadurch gekennzeichnet, dass** der Diodenstrom annähernd übergangsfrei umgeschaltet ist und insbesondere im wesentlichen ein Rechtecksignal bildet.

6. Markierungsvorrichtung nach einem der Ansprüche 1 bis 5, **dadurch gekennzeichnet, dass** innerhalb eines ersten Zyklusabschnitts wenigstens vier Laserpulse auftreten,

7. Markierungsvorrichtung nach einem der Ansprüche 1 bis 6, **dadurch gekennzeichnet, dass** die Länge des ersten Zyklusabschnitts wenigstens 15 %, insbesondere wenigstens 25 % der Zyklusdauer beträgt.

8. Markierungsvorrichtung nach einem der Ansprüche 1 bis 7, **dadurch gekennzeichnet, dass** die Länge des ersten Zyklusabschnitts höchstens 75 %, insbesondere höchstens 65 % beträgt.

9. Markierungsvorrichtung nach einem der Ansprüche 1 bis 7, **dadurch gekennzeichnet, dass** die Länge des ersten Zyklusabschnitts wenigstens 300 µs beträgt.

10. Markierungsvorrichtung nach einem der Ansprüche 1 bis 9, **dadurch gekennzeichnet, dass** die Steuereinrichtung zur Steuerung des Diodenstroms in wenigstens einer weiteren Betriebsart eingerichtet ist.

11. Markierungsvorrichtung nach Anspruch 10, **dadurch gekennzeichnet, dass** die Steuereinrichtung zur Ansteuerung der Diodenanordnung in einer Betriebsart mit konstantem Diodenstrom eingerichtet ist.

12. Markierungsvorrichtung nach einem der Ansprüche 1 bis 11, **dadurch gekennzeichnet, dass** die Steuereinrichtung zur Veränderung zumindest einer der Größen aus Zyklusdauer, Länge des ersten und/oder zweiten Abschnitts und oberen Stromwert während eines zeitlich zusammenhängenden Markierungsvorgangs eingerichtet ist.
